# EUROPÄISCHE PATENTSCHRIFT

(11) **EP 2 593 757 B1**
(45) Veröffentlichungstag und Bekanntmachung des Hinweises auf die Patenterteilung: **30.08.2017**
(21) Anmeldenummer: 11738411.5
(22) Anmeldetag: 01.07.2011
(51) Int. Cl.: G01F 23/284, G01S 7/03, G01R 27/32, G01N 22/00, H01Q 1/22, H01Q 13/02, H01Q 19/08, G01S 13/88

(54) **FÜLLSTANDSMESSGERÄT ZUR ERMITTLUNG UND ÜBERWACHUNG EINES FÜLLSTANDES EINES IM PROZESSRAUM EINES BEHÄLTERS BEFINDLICHEN MEDIUMS MITTELS EINEM MIKROWELLEN-LAUFZEITMESSVERFAHREN**
MICROWAVE FLUID LEVEL SENSOR MEASURING THE FLUID LEVEL IN A CONTAINER USING A TIME OF FLIGHT MEASUREMENT
APPAREIL DE MESURE DE NIVEAU DE REMPLISSAGE SERVANT À DÉTERMINER ET À SURVEILLER LE NIVEAU D'UN AGENT SE TROUVANT DANS LA CHAMBRE DE TRAITEMENT D'UN CONTENANT PAR UN PROCÉDÉ DE MESURE DU TEMPS DE PARCOURS PAR MICRO-ONDES

(30) Priorität: 13.07.2010 DE 102010031276
(43) Veröffentlichungstag der Anmeldung: 22.05.2013
(73) Patentinhaber: Endress+Hauser GmbH+Co. KG, 79689 Maulburg (DE)
(72) Erfinder: CHEN, Qi, 79689 Maulburg (DE); BERGMANN, Eric, 79585 Steinen (DE); FEISST, Klaus, 79252 Stegen (DE)
(74) Vertreter: Andres, Angelika Maria
(86) Internationale Anmeldenummer: PCT/EP2011/061088
(87) Internationale Veröffentlichungsnummer: WO 2012/007294

(56) Entgegenhaltungen:
- WO-A1-01/88488
- DE-A1-102005 036 715
- US-A- 5 262 743

## Beschreibung

Die vorliegende Erfindung betrifft ein Füllstandsmessgerät zur Ermittlung und Überwachung eines Füllstandes eines im Prozessraum eines Behälters befindlichen Mediums mittels einem Mikrowellen-Laufzeitmessverfahren, bestehend aus einem Messumformer und einer Antenneneinheit, die zumindest aus einem Hohlleiter und einem Abstrahlelement aufgebaut ist, wobei ein mikrowellen-durchlässiges Prozess-trennelement in den Hohlleiter zur Prozesstrennung zwischen dem Messumformer und dem den Prozessraum berührenden hornförmigen Abstrahlelement eingefügt ist.

Die Anmelderin ist im Bereich der industriellen Automations- und Prozesssteuerungs-technik tätig und stellt industrielle Messgeräte, bzw. Feldgeräte her. Sie vertreibt diese Feldgeräte z.B. zur Füllstandsbestimmung eines Mediums in einem Behälter u. a. unter dem Namen Micropilot, Levelflex oder Deltapilot.

Eine bekannte Messmethode aus einer Vielzahl von Messmethoden zur Ermittlung des Füllstands in einem Behälter ist die Laufzeit-Messmethode. Bei dieser Messmethode werden beispielsweise Mikrowellen über eine Antennenvorrichtung ausgesendet und die an der Mediumsoberfläche reflektierten Echowellen detektiert, wobei die Laufzeit des Messsignals ein Maß für den Abstand ist. Aus der halben Laufzeit lässt sich demgemäß der Füllstand des Mediums in einem Behälter ermitteln. Die Echokurve stellt hierbei den gesamten Signalverlauf als Funktion der Zeit dar, wobei jeder Messwert der Echokurve der Amplitude eines in einem bestimmten Abstand an einer Oberfläche reflektierten Echosignals entspricht. Die Laufzeit-Messmethode wird im Wesentlichen in zwei Ermittlungsverfahren eingeteilt: Bei der Zeitdifferenzmessung wird die Zeit, die ein breitbandiger Wellensignalimpuls für eine zurückgelegte Wegstrecke benötigt, ermittelt. Bei der Kippfrequenzdifferenzmessung (FMCW - Frequency-Modulated Continuous Wave) wird das ausgesendete, frequenzmodulierte Hochfrequenzsignal zum reflektierten, empfangenen, frequenzmodulierten Hochfrequenzsignal ermittelt. Im Weiteren wird keine Beschränkung auf ein spezielles Ermittlungsverfahren gemacht.

Bei bestimmten Prozessanwendungen sind die Messgeräte bzw. deren Sensorelemente extremen Bedingungen, wie z.B. hohen Temperaturen, hohen Drücken und/oder chemisch aggressiven Stoffen, ausgesetzt. Insbesondere Mikrowellen-Füllstandsmessgeräte weisen temperatur- und/oder druckempfindliche Bauteile auf, wie beispielsweise die Messgerätelektronik und Sende- und/oder Empfangselemente für die Mikrowellen. Außerdem werden die Abstrahleigenschaften der Antennen der Mikrowellen-Füllstandsmessgeräte durch Mediumsablagerungen verändert.

Um die Messelektronik im Messumformer und die Mikrowellensignaleinkopplung vor den hohen Temperaturen, hohen Drücken und vor den aggressiven chemischen Stoffen zu schützen, sowie die Abstrahlcharakteristiken der Antennen konstant zu halten, sind empfindliche Elemente der Sensorelemente, bzw. der Antennen prozessseitig mit Prozesstrennelementen hermetisch abgedichtet. Außerdem wird durch das Einfügen eines hermetisch dichten Prozesstrennelements in den Hohlleiter einer Hornantenne die größtmöglichste Sicherheit gewährleistet, da aufgrund eines zweiten "Sicherheitselements" der Prozess bei einer Trennung der modularen messaktiven Teile, wie z.B. einer Einkoppeleinheit/Erregerelement oder der Messgeräteelektronik, von dem messpassiven Teil, wie z.B. der Antenne, bei einer Wartung oder Reparatur des Füllstandsmessgeräts verschlossen bleibt.

In der WO 2003/046491 A1 ist eine Antenne zur Füllstandsmessung mittels einer zumindest teilweisen Befüllung mit einem dielektrischen Material oder einem scheibenförmigen dielektrischen Element vor aggressiven chemischen Medien und hohen Temperaturen zu schützen beschrieben.
In der US 5,115,218 B2 ist ein Mikrowellen durchlässiges Prozesstrennelement beschrieben, dessen konische Formgebung den Brewster-Winkel beachtet, der den Winkel für die Totaltransmission der Strahlungsenergie durch ein dielektrisches Medium vorgibt.
In der WO 2000/29819 A1 ist ein Mikrowellen Prozesstrennfenster für ein Bypass-Rohr gezeigt, dass eine konische Formgebung aufweist und über O-Ringdichtungen zwischen Prozessanschlussstutzen am Behälter und Geräteanschlussstutzen hermetisch dicht eingebracht ist.

Der WO 01/88488 A1 beschreibt ein Füllstandsmessgerät mit einer Antenne, mit einem Hohleiter, mit einer Hohlleitereinkopplung in Form einer Platine und eines darauf angebrachten elektrisch leitfähigen Körpers, welche in den Hohlleiter hineinragen.

In der DE 10 2005 036715 A1 ist ein Füllstandradarsensor beschrieben mit einem Trennelement zur Isolation einer Antenne von einer Speisevorrichtung, wobei das Trennelement eine Dicke aufweist, die beispielsweise bei 0,5 mm liegt.

In der DE 10 2007 026 389 A1 ist eine Hochtemperaturprozesstrennung, die ein Dämpfungselement aufweist, das zur Verbesserung der Messung im Nahbereich der Antenne durch Reduktion des Klingelverhaltens führt, gezeigt.

Nachteilig an den im Stand der Technik gezeigten Prozesstrennelementen ist, dass die Kunststoffe des Prozesstrennelements und die Dichtungs-Elastomere im Temperaturbereich > 200°C nicht dauerbeständig sind und mit steigender Temperatur sehr schnell zunehmend Alterungs- und demzufolge Undichtigkeitserscheinungen aufweisen.

Der Erfindung liegt daher die Aufgabe zugrunde, ein reflektionsarmes und resonanzfreies Prozesstrennelement für ein Füllstandsmessgerät vorzuschlagen, welches eine hohe thermische und chemische Beständigkeit aufweist, und das insbesondere kostengünstig und einfach herzustellen ist.

Die Aufgabe wird gelöst durch den Gegenstand des Anspruchs 1. Weiterbildungen und Ausgestaltungen der Erfindungen finden sich in den Merkmalen der jeweils abhängigen Ansprüche 2 - 10 wieder.

Ein erfindungsgemäßes Füllstandsmessgerät zur Ermittlung und Überwachung eines Füllstandes eines im Prozessraum eines Behälters befindlichen Mediums mittels einem Mikrowellen-Laufzeitmessverfahren besteht aus einem Messumformer und einer Antenneneinheit, die zumindest aus einem Hohlleiter und einem Abstrahlelement aufgebaut ist, wobei ein mikrowellen-durchlässiges Prozesstrennelement an dem Hohlleiter zur Prozesstrennung zwischen dem Messumformer und dem den Prozessraum berührenden homförmigen Abstrahlelement eingefügt ist.

Erfingdungsgemäß ist das Prozesstrennelement als ein dielektrischer Hohlkörper mit zumindest einem der Form des Hohlleiters angepassten, rohrförmigen Hohlkörperbereich und daran in Richtung des Abstrahlelements anschließenden, konjugierenden Spitzhohlkörperbereich mit einer auf die Reflexion der Mikrowellensignale angepassten Wandstärke ausgestaltet, und ein Absorberelement ist zwischen dem Hohlleiter und dem Prozesstrennelement eingebracht.

In einer ersten Ausgestaltung ist die angepasste Wandstärke des Prozesstrennelements, insbesondere im Spitzhohlkörperbereich, stetig auf ungefähr die halbe Wellenlänge des ausgesendeten Mikrowellensignals oder auf ein ganzzahliges Vielfaches davon ausgestaltet, und ein Absorberelement ist zwischen dem Hohlleiter und dem Prozesstrennelement eingebracht.

In einer zweiten Ausgestaltung ist die angepasste Wandstärke des Prozesstrennelements, insbesondere im Spitzhohlkörperbereich, in einem Bereich von einem bis fünf Millimeter ausgestaltet.

Gemäß der ersten oder zweiten Ausgestaltung ist der rohrförmige Hohlkörperbereich des Prozesstrennelements als ein Kreiszylinder ausgestaltet und der Spitzhohlkörper-bereich des Prozesstrennelements in Richtung des Prozessraumes weist eine kegelförmige Formgebung auf.

Gemäß der ersten oder zweiten Ausgestaltung ist der rohrförmige Hohlkörperbereich des Prozesstrennelements als ein Rechteckzylinder ausgestaltet und der Spitzhohlkörperbereich des Prozesstrennelements in Richtung des Prozessraumes weist eine keilförmige oder pyramidenförmige Formgebung auf.

Weiterhin erfindungsgemäß ist in dem rohrförmigen Hohlkörperbereich des Prozesstrennelements bis zum Spitzhohlkörperbereich ein mit dem metallischen Hohlleiter elektrisch verbundenes metallisches Rohr oder eine mit dem metallischen Hohlleiter elektrisch verbundene, metallische Beschichtung der Innenwand des rohrförmigen Hohlkörperbereichs des Prozesstrennelements eingebracht.

In einer besonders vorteilhaften Ausgestaltung weist der Spitzhohlkörperbereich einen definierten Spitzwinkel auf, wobei der halbe Spitzwinkel einem neunziggrad bzw. rechten Winkel minus dem Brewster-Winkel, der auf die Fläche des Spitzhohlkörperbereichs einstrahlenden Mikrowellensignale, entspricht.

In einer ergänzenden Ausgestaltung weist das Prozesstrennelement in Richtung des Hohlleiters einen Kragenbereich am rohrförmigen Hohlkörperbereich auf, wodurch eine dichte Klemmbefestigung des Kragenbereichs des Prozesstrennelerrments mittels eines verschraubten und/oder verschweißten Stutzenelements an dem Hohlleiter ausgestaltet ist.

In einer weiteren Ausgestaltung verschließt das Prozesstrennelement mittels zumindest einer Dichtung, insbesondere einer O-Ring-Dichtung, Graphitstopfbuchs-Dichtung, oder einer Keramik-Metall-Lötverbindung, die den Hohlleiter hermetisch abdichtet.

Um eventuell auftretende Hochfrequenz-Resonanzen im dielektrischen Körper zu unterdrücken und die Abstrahleigenschaften der Antenneneinheit zu verbessern, ist das Absorberelement aus einem Hochfrequenz-Dämpfungsmaterial, und das Absorberelement ist insbesondere eine Siliziumcarbid-Scheibe.

In einer zweckvollen Ausgestaltung ist das Prozesstrennelement aus einem Keramikmaterial, einem Kunststoffmaterial, einem dielektrischen Verbundmaterial, wie z.B. einem Faserverstärktem Kunststoff, einem Keramikgefülltem Kunststoff oder einem Glas ausgestaltet. Technische Keramik ist aufgrund ihrer hohen Druckfestigkeit für diese Art der Konstruktion besonders geeignet.

Weitere Einzelheiten, Merkmale und Vorteile des Gegenstandes der Erfindung ergeben sich aus der nachfolgenden Beschreibung mit den zugehörigen Zeichnungen, in denen bevorzugte Ausführungsbeispiele der Erfindung dargestellt sind. Die Bauteile oder Bauteilgruppen der in den Figuren dargestellten Ausführungsbeispiele, die sich in ihrem Aufbau und/oder in ihrer Funktion entsprechen, sind zur besseren Übersicht und zur Vereinfachung mit gleichen Bezugszeichen versehen. Es zeigen:
Fig. 1 eine schematische Schnittdarstellung eines Füllstandsmessgeräts der Prozessmesstechnik mit einer Hornantenne und dem erfindungsgemäßen Prozesstrennelement,
Fig. 2 eine Schnittdarstellung eines Ausführungsbeispiels des erfindungsgemäßen Prozesstrennelements,
Fig. 3 eine vergrößerte Darstellung des erfindungsgemäßen Prozesstrennelements des Füllstandsmessgeräts der Prozessmesstechnik aus Fig. 2,
Fig. 4 eine dreidimensionale Schnittdarstellung des erfindungsgemäßen Prozesstrennelements, und
Fig. 5 eine Komplettansicht des erfindungsgemäßen Prozesstrennelements.

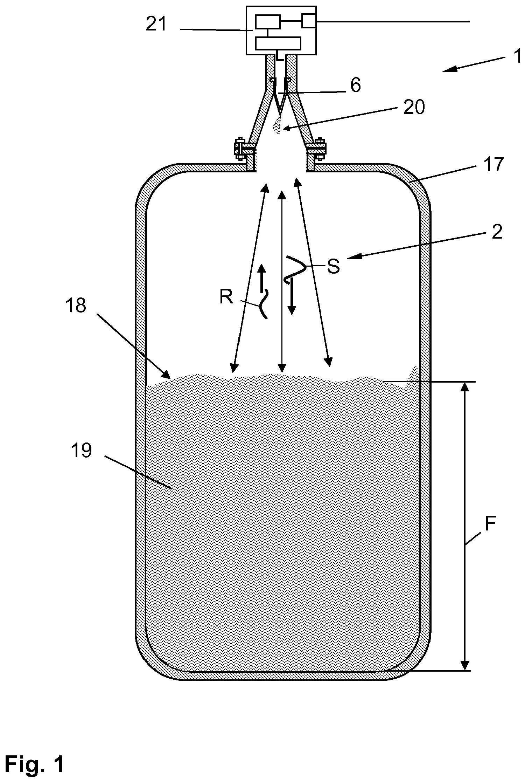

In Fig. 1 ist ein nach dem Laufzeit-Messverfahren arbeitendes Füllstandsmessgerät 1 zur Ermittlung des Füllstand F eines Mediums 19 gezeigt, das auf einem Behälter 17 an einem Stutzen montiert ist. Bei dem gezeigten Füllstandsmessgerät 1 handelt es sich um ein frei in den Prozessraum Mikrowellen abstrahlendes Abstrahlelement 5, insbesondere eine Hornantenne, mit einem Messumformer 21. Der Messumformer 21 weist zumindest eine Sende-/Empfangseinheit, die die Erzeugung der Sendesignale S und den Empfang der Reflexionssignale R von Mikrowellensignalen 2 ausführt, eine Regel-/Auswerteeinheit, die zur signaltechnische Verarbeitung der Mikrowellensignale 2 und zur Steuerung des Füllstandsmessgeräts 1 befähigt, und außerdem eine Kommunikationseinheit, die die Kommunikation über ein Bussystem sowie die Energieversorgung des Füllstandsmessgeräts 1 steuert und regelt, auf. Das Abstrahlelement 5 ist in diesem Ausführungsbeispiel beispielsweise als eine Hornantenne ausgeführt, jedoch kann das Abstrahlelement 5 als jede bekannte Antennenform, wie z.B. Stab-oder Planarantenne ausgestaltet sein. In der Sende-/Empfangseinheit wird ein Mikrowellensignal 2 beispielsweise als Sendesignals S erzeugt und über die Antenneneinheit 3 in einer vorgegebenen Abstrahlcharakteristik in Richtung Medium 19 abgestrahlt. Nach einer von der zurückgelegten Strecke x abhängigen Laufzeit t werden die an der Grenzfläche 18 des Mediums 19 reflektierten Sendesignale S als Reflexionssignal R wieder von der Antenneneinheit 3 und der Sende-/Empfangseinheit empfangen. Die nachgeschaltete Regel-/Auswerteeinheit ermittelt aus den Reflexionssignalen R eine Echokurve 22, die die Amplituden Amp der Reflexionssignale R in Abhängigkeit der zurückgelegten Strecke x oder der entsprechenden Laufzeit t darstellt. Durch eine Analog/Digitalwandlung der analogen Echokurve 22 wird eine digitalisierte Hüllkurve erzeugt.

Die Prozesstrennung und Abdichtung einer Antenneneinheit 3 mittels einem erfindungsgemäßes Prozesstrennelement 6 aus Fig. 1 - 5 ist für den praktischen Einsatz des Füllstandsmessgeräts 1 im Prozess unentbehrlich, da das erfindungsgemäße Prozesstrennelement 6 die Antenneneinheit 3 vor chemisch aggressiven Medien schützt und die Beeinflussung der Abstrahlungseigenschaft der Antenneneinheit aufgrund von Ansatz 20 des Mediums 19 verhindert. In der Füllstandsmesstechnik werden an die Prozesstrennung einer Radar-Antenneneinheit 3 besondere hohe technische Anforderungen gestellt, da die Einsatzbedingungen bezüglich Druck, Temperatur, Beständigkeit gegen Prozessmedien 19 ganz unterschiedlich ausfallen können.

Durch das erfindungsgemäße Prozesstrennelement 6 sollten die Mikrowellensignale 2 möglichst reflektionsarm und resonanzfrei transmittiert werden, weshalb nur dielektrische Materialien zur Ausgestaltung als Prozesstrennelement 6 in Betracht kommen. Das Prozesstrennelement 6 sollte unter anderem die folgenden stofflichen Eigenschaften aufweisen:
- hohe Temperaturbeständigkeit
- hohe chemische Beständigkeit
- resistent gegen Wasserdampf
- hohe Druckbelastbarkeit
- gute Dichtheit mit geringer Diffusion des Mediums durch das Material
- gutes Abtropfverhalten und Unempfindlichkeit gegenüber Ansatz und Kondensat

Das Prozesstrennelement 6 von den Füllstandsmessgeräten 1, die nach einem Laufzeitmessverfahren von Mikrowellensignalen 2 die Distanz zum Medium 19 ermitteln, ist üblicherweise zwischen der Einkopplung der koaxialen Signalführung in den Hohlleiter 4 der Antenneneinheit 3 und dem Abstrahlelement 5, z.B. einer Hornantenne, angeordnet. Dieses Prozesstrennelement 6 soll verhindern, dass Medium 19 aus dem Prozess in die empfindliche Einkoppelstruktur und den Messumformer 21 eindringen und/oder in die Umgebung austreten kann.

Das Prozesstrennelement 6 ist nach dem Stand der Technik für Hornantennen ein mit einem Dielektrikum gefüllter Hohlleiter, wie beispielsweise in der US 3,594,667 B1 gezeigt, dessen Füllmaterial sich an der Stelle konisch verjüngt, an der sich das Horn der Hornantenne beginnt aufzuweiten. Als dielektrische Materialien werden meist Polymer-Materialien, insbesondere PTFE (Polyterafluorethylen) oder PEEK (Polyetheretherketone) eingesetzt. Die erfindungsgemäßen Prozesstrennelemente 6 aus diesen Kunststoffmaterialien werden in Kombination mit der Elastomer-Dichtung hermetisch abdichtend in den Hohleiter 4 eingesetzt. Der Durchmesser des Prozesstrennelements 6 im Bereich des Hohlleiters 4 wird so gewählt, dass im gefüllten Hohlleiter 4 bei der max. Arbeitsfrequenz nur die Grundmode der Mikrowellensignale 2 ausbreitungsfähig ist und es somit zu keinen Störresonanzen höherer Moden im Hohlleiter 4 kommt. Die Prozesstrennelemente 6 aus Kunststoff haben den Vorteil, dass diese sehr preiswert und einfach herzustellen sind. Die Nachteile liegen in der begrenzten Einsatztemperatur von maximal 200°C dieser eingesetzten Kunststoffmaterialien, insbesondere der Elastomer-Dichtungsmaterialien, und in der begrenzten Druckbelastbarkeit durch mindere Festigkeit und Flieseigenschaften des Polymermaterials, insbesondere PTFE (Polyterafluorethylen).

Oberhalb dieser Einsatztemperatur von 200°C bleibt ausschließlich Keramik als dielektrisches Material übrig, da technische Gläser bei diesen erhöhten Temperaturen von über 200°C nicht gegen Wasser und auftretenden Wasserdampf beständig sind. Diese keramischen Materialien weisen meist eine hohe Temperatur- und/oder chemische Beständigkeit, sowie höhere Druckfestigkeit auf. Die Nachteile dieser keramischen Materialien zur Verwendung als Prozesstrennelement 6 liegen in der Sprödigkeit und höheren Dielektrizitätszahl als bei Kunststoffen, setzt man keramische Werkstoffe mit Dielektrizitätskonstanten größer als 2 ein. Die hohe Dielektrizitätszahl führt dazu, dass bei einem deutlich kleineren Durchmesser und einer relativ hohen Arbeitsfrequenz, insbesondere über 20 GHz, der Anteil der von dem Prozesstrennelement 6 in den Hohlleiter 4 zurückreflektierten Mikrowellensignale stark erhöht ist und dadurch Störsignale aufgrund von Hochfrequenz-Resonanzen der höheren Moden des Mikrowellensignals 2 erzeugt werden können. Diese verstärkte Reflexion des Mikrowellensignals 2 an dem Prozesstrennelement 6 aufgrund der höheren Dielektrizitätszahl des Materials hat weiterhin den Nachteil, dass weniger Energie als Sendesignal S in den Prozessraum, bzw. Behälter 17 abgestrahlt wird. Außerdem ist durch die höhere Dielektrizitätszahl auch die Empfindlichkeit der Antenneneinheit gegen Kondensat erheblich verschlechtert. Beispielsweise beträgt der Durchmesser des Prozesstrennelements 6 aus einer Aluminiumoxid-Keramik mit einer mono-modigen Ausbreitungscharakteristik des Mikrowellensignals 2 bei 26 GHz ungefähr 2,7 mm. Diese geringen Durchmesser der Prozesstrennelemente 6 bei diesen hohen Anregungsfrequenzen sind nur mit einem hohem technischem Aufwand und hohen Kosten herzustellen. Eine Möglichkeit, dieses Problem zu umgehen besteht darin, den Durchmesser des Prozesstrennelements 6 größer, also multi-modig auszulegen. Dieses größer dimensionierte, multi-modige Prozesstrennelement 6 in einem Hohlleiter 4 verursacht die Bildung von höheren Moden im Hohlleiter 4 aufgrund von Hochfrequenz-Resonanzen. Diese Hochfrequenz-Resonanzen werden in der Fachsprache auch als Hochfrequenz - "Klingeln" bezeichnet und können die Echos des Füllstandes in bestimmten Messbereichen überdecken, wodurch die Auswertung der Laufzeit der Echoimpulse nicht mehr möglich ist und die Dynamik des Füllstandsmessgeräts 1 vermindert wird. In der DE 10 2007 026 389 A1 ist eine konstruktive Verbesserung der Antenneneinheit 3 zur Unterdrückung der Hochfrequenz-Resonanzen bzw. des "Klingelns" beschrieben, wobei das "Klingeln" mit dem Absorber 11 bedämpft wird. Durch den Absorber 11 wird im Gegenzug eine geringere Antennenverstärkung verursacht und die multi-modige Abstrahlung in den Prozessraum durch höhere Moden muss mit dieser Konstruktion in Kauf genommen werden.

Die erfindungsgemäße Hochtemperaturantenne zeigt in Fig. 1 - 5 eine alternative Konstruktion, die ein Prozesstrennelement 6 aus einem dielektrischen dünnwandigen Hohlkörper 7 umfasst. Die Wandstärke d des Prozesstrennelements 6 beträgt mindestens im Spitzhohlkörperbereich 9 ungefähr λ/2 oder ein Vielfaches davon, wobei λ der Mittenwellenlänge des breitbandig angeregten Mikrowellensignals 2 entspricht. Wird das Mikrowellensignal 2 über einen runden luftgefüllten Hohlleiter 4 in den Hohlkörperbereich 8 eingespeist, ist der Spitzhohlkörperbereich 9 als ein Hohlkegel ausgebildet. Wird hingegen das Mikrowellensignal 2 über einen rechteckigen luftgefüllten Hohlleiter 4 in den Hohlkörperbereich 8 eingespeist, so ist der Spitzhohlkörperbereich 9 als eine Hohlpyramide ausgebildet. Die quasi-linear polarisierte TE-11 Mode verlässt den beispielsweise runden Hohlleiter 4, durchläuft den als Hohlkegel ausgebildeten Spitzhohlkörperbereich 9 mit einer Wandstärke d von λ/2 oder einem Vielfachen davon, wird dann über das Abstrahlelement 5, in Fig. 1 - 5 als Horn dargestellt, abgestrahlt. Die konusförmige Konstruktion erhöht die HF-Bandbreite und Messdynamik der Antenneneinheit 3 und verbessert gleichzeitig die Kondensat-Unempfindlichkeit im Vergleich zu planaren Hohlleiterfenstern und zu einem vollständig mit einem Dielektrikum gefüllten Hohlleiter 4.

Je nach Ausgestaltung der Konstruktion der Antenneneinheit 3 kann sich ein großer Hohlkörper 4 im rohrförmigen Hohlleiterbereich 8 bilden, in dem wiederum Hochfrequenz-Resonanzen von höheren Moden des Mikrowellensignals 2 entstehen können. Damit sich diese Resonanz-Signale nicht störend auf die Ermittlung der Echos der ausgesendeten Sendesignale S auswirken, wird entsprechend ein Absorber 11 zur Bedämpfung der Resonanz-Signale hinzugefügt. Aufgrund der Druckbelastbarkeit des Prozesstrennelements 6 mit einem Spitzhohlkörperbereich 9, dessen Wandstärke d auf die Hälfte der Mittenwellenlänge des Mikrowellensignals, d.h. λ/2 oder ein Vielfaches davon ausgelegt ist, ist diese erfindungsgemäße Hohlkörper 7 - Konstruktion des Prozesstrennelements 6 auf den Frequenzbereich kleiner 40 GHz beschränkt, da sonst die Stabilität des Prozesstrennelements 6 für hohe Drücke von bis zu einigen hundert Bar nicht mehr gewährleistet werden kann.

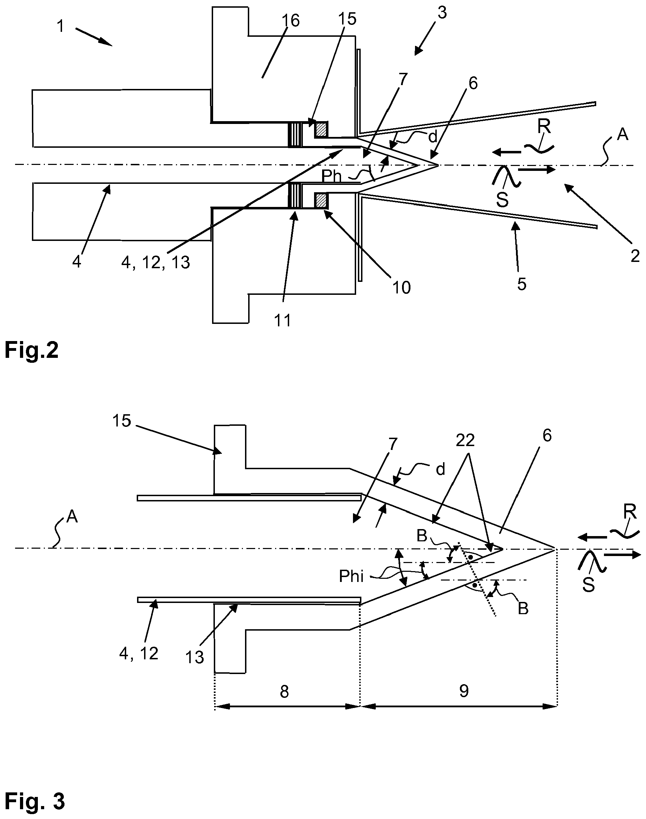

In Fig. 2 ist das erfindungsgemäße Prozesstrennelement 6 in einer Antenneneinheit 3 gezeigt. Die Antenneneinheit 3 besteht zumindest aus einem Hohlleiter 4 der in einen Prozessanschluss bzw. in ein Stutzenelement 16 so eingebracht ist, dass das erfindungsgemäße Prozesstrennelement 6 im Kragenbereich 15 mittels einer Dichtung 10 hermetisch abgedichtet und formschlüssig eingebracht ist. Hierzu wird beispielsweise in die Außenwand des Hohlleiters 4 ein entsprechendes Gewinde eingebracht, das in ein Gewinde in der Innenwand des Prozessanschlusses 16 eingeschraubt wird, so dass über die eingelegte Dichtung 10 eine Klemmbefestigung des Prozesstrennelements 6 im Kragenbereich 15 erfolgt. Als Dichtung wird hier beispielsweise eine metallische Dichtungsscheibe eingelegt. Die verschraubte Klemmverbindung wird im montierten Zustand beispielsweise zusätzlich durch eine Verschweißung des Prozessanschlusses 16 mit dem Hohlleiter 4 an der offenen Verbindungsstelle hermetisch abdichtend befestigt und gesichert. Zusätzlich wird zur Dämpfung von ungewollt auftretenden Hochfrequenz - Resonanzen ein Absorber 11 in Form einer Silizium-Karbid-Scheibe zwischen die Stoßstelle des Hohlleiters 4 und die Stoßstelle im Kragenbereich 15 des Prozesstrennelements 6 eingelegt. Zur Verbesserung der Abstrahlcharakteristik bzw. zur Verbesserung der ebenen Wellenfront des Mikrowellensignals 2 ist in Abstrahlrichtung eine Hornantenne als Abstrahlelement 5 an dem Prozessanschluss 16 so angebracht, dass sich das Antennenhorn an der Stelle beginnt aufzuweiten, an der der Spitzhohlkörperbereich 9 beginnt, bzw. sich der Durchmesser des Hohlkegels, bzw. der Hohlpyramide verjüngt. Der Hohlleiter 4 ist beispielsweise entweder über ein dünnes, rohrförmiges Element in den Hohlkörperbereich 8 des Hohlkörpers 7 des Prozesstrennelements 6 weiter hineingeführt, oder die Innenwand 13 des Hohlkörpers 7 des erfindungsgemäßen Prozesstrennelements 6 im Hohlkörperbereich 8 wird mit einer metallischen, geschlossenen oder teilweise offenen Beschichtung 12 versehen, das mit dem restlichen Hohlleiter 4 elektrisch verbunden ist. Durch diese Weiterführung des Hohlleiters 4 in den rechteckförmigen oder zylindrischen Hohlkörperbereich 8 kann einerseits eine weitere mechanische Stabilisierung der Konstruktion des Prozesstrennelements 6 erreicht werden, andererseits werden Störreflexionen im Hohlkörperbereich 8 des Prozesstrennelements 6 aufgrund von Durchmesser-Veränderungen der Hohlleiterstruktur 4 vermieden.

In Fig. 3 ist eine vergrößerte Teilansicht der Fig. 2 dargestellt, die sich nur auf das Prozesstrennelement 6 und die Weiterführung des Hohlleiters 4 in den Hohlkörper 7 beschränkt. Das erfindungsgemäße Prozesstrennelement 6 ist als Hohlkörper 7 ausgestaltet und weist einen Kragenbereich 15 mit einem daran anschließenden Hohlkörperbereich 8 und Spitzkörperbereich 9 auf. Der metallische Hohlleiter 4 ist über die gesamte Länge in den Hohlkörperbereich 8 eingeführt, bzw. eine metallische Beschichtung 12 der Innenwand 13 im Hohlkörperbereich 8 ergibt einen Hohlleiter 4 in diesem Hohlkörperbereich 8. Das Prozesstrennelement 6 ist bei einem kreisrunden Hohlleiter 4 aus zumindest einem Kreiszylinder im Hohlkörperbereich 8 mit einem angrenzenden, kreissymmetrischen Spitzhohlkegel im Spitzhohlkörperbereich 9 aufgebaut. Das Prozesstrennelement 6 ist somit rotationssymmetrisch zu einer Achse A ausgestaltet. Eine andere Ausgestaltung ergibt sich bei der Verwendung eines rechteckigen Hohlleiters 4 in der Antenneneinheit 3, die aus zumindest einem Rechteckzylinder im Hohlkörperbereich 8 und einem daran angrenzenden Hohlpyramide in dem Spitzhohlkörperbereich 9 ausgestaltet ist. In einer ergänzenden Ausgestaltung, die nicht in den Figuren explizit dargestellt ist, wird der Spitzhohlkegel oder die Hohlpyramide in einen Ebenenbereich herunter gebrochen, so dass sich entsprechende Fresnel-Strukturen ergeben. Der Spitzkörperbereich 9 weist die Wandstärke d in einer Dicke von ungefähr der halben Mittenwellenlänge λ/2 des ausgesendeten Mikrowellensignale 2 oder einem Vielfachen davon auf. Der Spitzwinkel Phi der Seiten 22 des Hohlkörpers 7 im Spitzhohlkörperbereich 9 weist zu einer in Abstrahlrichtung der Mikrowellensignale 2 zeigenden Achse A einen Spitzwinkel Phi, der dem Rechtenwinkel bzw. dem Winkel der Flächennormalen der Seiten 22 minus dem Brewster-Winkel B der Sendesignale S und/oder Reflexionssignale R der Mikrowellenstrahlen entspricht, auf. Die Mikrowellensignale 2, die auf die Seiten 22 des Hohlkörpers 7 in dem Spitzhohlkörperbereich 9 auf die Grenzfläche zwischen dem luftgefüllten Hohlleiter 4 und dem dielektrischen Material des Prozesstrennelements 6 mit unterschiedlichen Brechungszahlen treffen, werden gemäß den fresnelschen Formeln reflektiert bzw. durch das Material des Prozesstrennelements 6 transmittiert. Nach den fresnelschen Formeln hängt das Reflexionsvermögen, sowohl vom Einfallswinkel, bzw. Brewster-Winkel B und von den Brechungszahlen der Materialien, sowie von der Polarisation des einfallenden Lichts ab. Für die Mikrowellensignal bzw. Mikrowellenstrahlung 2 mit einer Polarisation parallel zu der Einfallsebene, welches mit dem Brewster-Winkel B einfällt, wird die Reflexion des Mikrowellensinals 2 vollständig aufgehoben und die Mikrowellensignale 2 werden vollständig durch die Oberfläche und das Material des Prozesstrennelements transmittert.

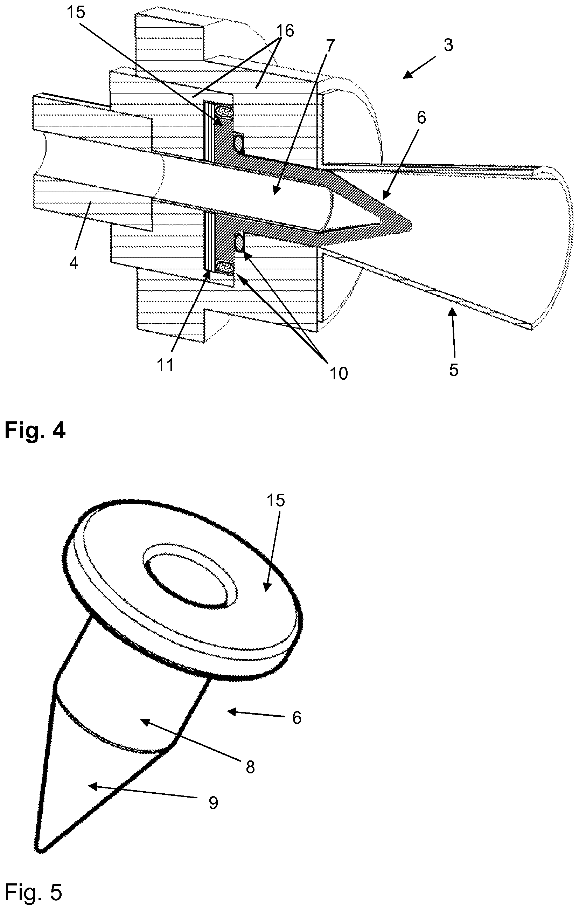

In Fig. 4 ist eine dreidimensionale Längsschnittdarstellung der erfindungsgemäßen Antenneneinheit 3 offenbart. Das erfindungsgemäße Prozesstrennelement 6 aus Fig. 1 bis 3 ist in dieser Ausgestaltung zwischen einem ersten und einem zweiten Teil eines mehrteiligen Prozessanschlusses, bzw. Stutzenelements 16 eingebracht. An den Prozessanschluss 16 ist in Abstrahlrichtung ein Antennenhorn als Abstrahlelement 5 zur Anpassung der Abstrahlcharakteristik der in den Prozessraum freiabstrahlenden Mikrowellensignale 2 angebracht. Der erste und zweite Teil des mehrteilig ausgestalteten Prozessanschlusses, bzw. Stutzenelements 16 sind hierbei beispielsweise über ein Gewinde so ineinander geschraubt, dass Sie das Prozesstrennelement 6 im Kragenbereich 15 mechanisch einklemmen. Zur hermetischen Abdichtung des Prozesstrennelements sind im Kragenbereich zwei Dichtelemente, z. B. Metall-O-Ringe, eingebracht, die die Klemmverbindung zwischen dem Prozessanschluss 16 und dem Prozesstrennelement 6 dichten. Zur Absorption von möglichen Störmoden aufgrund von Hochfrequenz-Resonanzen ist ein Absorber 11 in diese Klemmverbindung integriert. Der Hohlleiter 4 ist in das Prozesstrennelement bis zum Spitzhohlkörperbereich hineingeführt bzw. weitergeführt, so dass sich die Mikrowellensignale 2 in diesem ungestörten Hohlleiter 4 bis zum Spitzhohlkörperbereich 9 bei einem kreiszylindrischen Hohlleiter 4 im ungestörten, quasi-linear polarisierte TE11 Mode ausbreiten können. Durch die Ausgestaltung der Seiten 22 des Spitzhohlkörperbereich 9 zur Ausbreitungsachse A der Mikrowellensignale 2 in einem Brewster-Winkel PHI und mit einer Wandstärke d von der halben Mittenwellenlänge λ/2 der Mikrowellensignale 2 wird nahezu der gesamte Anteil des auszusendenden Mikrowellensignals 2 transmittiert und ggf. nur ein geringer Anteil in den Hohlleiter 4 als Störresonanz zurückreflektiert. In Fig. 5 ist eine Komplettansicht des erfindungsgemäßen Prozesstrennelements 6 mit einem Kragenbereich 15 als Kreisscheibe, dem Hohlkörperbereich 8 als Kreiszylinder und dem Spitzhohlkörperbereich 9 als Hohlkegel gezeigt. Diese Elemente sind beispielsweise in einem bekannten, keramischen Guss- oder Prägeverfahren herstellbar und somit kostengünstig und einfach herzustellen.

Beispielsweise weist das in Fig. 4 -5 dargestellte Prozesstrennelement 6 bei einer Mittenfrequenz der Mikrowellensignale 2 von 26 GHz bestehend aus einem Aluminiumoxid-Keramik-Material einen Außendurchmesser von 13 Millimetern und einen Innendurchmesser von ungefähr 9 Millimetern auf. Das erfindungsgemäße Prozesstrennelement ist so ausgelegt, dass dieses den Prozessbedingungen von einer Temperaturbelastung T= - 270 bis 450°C und einer Druckbelastung im Bereich von p= -1 bis 160 bar ohne weiteres überstehen kann. Um eine Gasdichtheit der gesamten Antenneneinheit 3 garantieren zu können, wird der Keramik-Körper des Prozesstrennelements 6 primär mit einem Metall-O-Ring abgedichtet und sekundär eine Metall-Keramik-Lötverbindung eingebaut. Als Dämpfungsmaterial des Absorbers 11 wird beispielsweise eine ringförmige Scheibe aus einer Silizium-Carbid-Keramik im Kragenbereich 15 des Prozesstrennelements 6 verwendet.

Wird vergleichsweise das Prozesstrennelement 6 nach dem Stand der Technik als ein vollständig gefülltes, monomodiges Hohlleitertrennelemente ausgeführt, beträgt beispielsweise der erforderliche Außendurchmesser im zylindrischen Bereich des Prozesstrennelements 6 bei Verwendung einer Aluminiumoxid-Keramik und einer Frequenz der Mikrowellensignale 2 von 26 GHz ungefähr 2,7 mm. Diese Dimensionen sind nur mit erhöhtem Kostenaufwand und unter Verschlechterungen der Messgenauigkeit einsetzbar.

### Bezugszeichenliste

- 1: Füllstandsmessgerät
- 2: Mikrowellensignale
- 3: Antenneneinheit, Sende-/Empfangseinheit
- 4: Hohlleiter
- 5: Abstrahlelement, Sende-/Empfangselement
- 6: Prozesstrennelement
- 7: Hohlkörper
- 8: Hohlkörperbereich
- 9: Spitzhohlkörperbereich
- 10: Dichtung
- 11: Absorber
- 12: metallische Beschichtung
- 13: Innenwand
- 15: Kragenbereich
- 16: Stutzenelement
- 17: Behälter
- 18: Oberfläche, Grenzfläche
- 19: Medium, Prozessmedium
- 20: Ansatz, Tropfen
- 21: Messumformer
- 22: Seiten
- F: Füllstand
- d: Wandstärke
- Phi: Spitzwinkel
- B: Brewster-Winkel
- S: Sendesignal
- R: Reflexionssignal

## Patentansprüche

1. Füllstandsmessgerät zur Ermittlung und Überwachung eines Füllstandes (F) eines im Prozessraum eines Behälters (17) befindlichen Mediums (19) mittels einem Mikrowellen-Laufzeitmessverfahren, bestehend aus einem Messumformer (21) und einer Antenneneinheit (3), die zumindest aus einem Hohlleiter (4) und einem hornförmigen Abstrahlelement (5) aufgebaut ist, wobei ein mikrowellen-durchlässiges Prozesstrennelement (6) an dem Hohlleiter (4) zur Prozesstrennung zwischen dem Messumformer (21) und dem den Prozessraum berührenden hornförmigen Abstrahlelement (5) eingefügt ist,
**dadurch gekennzeichnet,**
**dass** das Prozesstrennelement (6) als ein Hohlkörper (7) mit zumindest einem der Form des Hohlleiters (4) angepassten, rohrförmigen Hohlkörperbereich (8) und daran in Richtung des hornförmigen Abstrahlelements (5) anschließenden Spitzhohlkörperbereich (9) mit einer auf die Reflexion der Mikrowellensignale (2) angepassten Wandstärke (d) ausgestaltet ist,
**dass** ein Absorberelement (11) zwischen dem Hohlleiter (4) und dem Prozesstrennelement (6) eingebracht ist, und
**dass** in dem rohrförmigen Hohlkörperbereich (8) des Prozesstrennelements (6) bis zum Spitzhohlkörperbereich (9) ein mit dem metallischen Hohlleiter (4) elektrisch verbundenes metallisches Rohr oder eine mit dem metallischen Hohlleiter (4) elektrisch verbundene, metallische Beschichtung (12) der Innenwand (13) des rohrförmigen Hohlkörperbereichs (8) des Prozesstrennelements (6) eingebracht ist.

2. Füllstandsmessgerät nach Anspruch 1,
**dadurch gekennzeichnet,**
**dass** die angepasste Wandstärke (d) des Prozesstrennelements (6), insbesondere im Spitzhohlkörperbereich (9), stetig auf ungefähr die halbe Wellenlänge (λ/2) des ausgesendeten Mikrowellensignals (2) oder auf ein ganzzahliges Vielfaches davon ausgestaltet ist.

3. Füllstandsmessgerät nach Anspruch 1,
**dadurch gekennzeichnet,**
**dass** die angepasste Wandstärke (d) des Prozesstrennelements (6), insbesondere im Spitzhohlkörperbereich (9), in einem Bereich von eins bis fünf Millimeter ausgestaltet ist.

4. Füllstandsmessgerät nach zumindest einem der Ansprüche 1, 2 oder 3,
**dadurch gekennzeichnet,**
**dass** der rohrförmige Hohlkörperbereich (8) des Prozesstrennelements (6) als ein Kreiszylinder ausgestaltet ist und der Spitzhohlkörperbereich (9) des Prozesstrennelements (6) in Richtung des Prozessraumes eine kegelförmige Formgebung aufweist.

5. Füllstandsmessgerät nach zumindest einem der Ansprüche 1, 2 oder 3,
**dadurch gekennzeichnet,**
**dass** der rohrförmige Hohlkörperbereich (8) des Prozesstrennelements (6) als ein Rechteckzylinder ausgestaltet ist und der Spitzhohlkörperbereich (9) des Prozesstrennelements (6) in Richtung des Prozessraumes eine keilförmige oder pyramiden-förmige Formgebung aufweist.

6. Füllstandsmessgerät nach zumindest einem der vorherigen Ansprüche,
**dadurch gekennzeichnet,**
**dass** der Spitzhohlkörperbereich (9) einen Spitzwinkel aufweist und dass der halbe Spitzwinkel Phi einem neunziggrad Winkel minus einem Brewster-Winkel (B) entspricht.

7. Füllstandsmessgerät nach zumindest einem der vorherigen Ansprüche,
**dadurch gekennzeichnet,**
**dass** das Prozesstrennelement (6) in Richtung des Hohlleiters (4) einen Kragenbereich (15) am rohrförmigen Hohlkörperbereich (8) aufweist, wodurch eine dichte Klemmbefestigung des Kragenbereichs (15) des Prozesstrennelement (6) mittels einem verschraubten und/oder verschweißten Stutzenelement (16) an dem Hohlleiter (4) ausgestaltet ist.

8. Füllstandsmessgerät nach zumindest einem der vorherigen Ansprüche,
**dadurch gekennzeichnet,**
**dass** das Prozesstrennelement (6) mittels zumindest einer Dichtung (10), insbesondere einer O-Ring-Dichtung, einer Graphitstopfbuchs-Dichtung, oder einer Keramik-Metall-Lötverbindung, den Hohlleiter (4) hermetisch gegen den Prozessraum abdichtend verschließt.

9. Füllstandsmessgerät nach zumindest einem der vorherigen Ansprüche,
**dadurch gekennzeichnet,**
**dass** das Absorberelement (11) insbesondere eine Siliziumcarbid-Scheibe ist.

10. Füllstandsmessgerät nach zumindest einem der vorherigen Ansprüche,
**dadurch gekennzeichnet,**
**dass** das Prozesstrennelement (6) aus einer Keramik-Material einem Kunststoffmaterial, einem dielektrischen Verbundmaterial, wie z.B. einem mit Fasern verstärktem Kunststoff, einem mit Keramik-Anteilen gefülltem Kunststoff oder einem Glas ausgestaltet ist.

## Claims

1. Level transmitter designed to determine and monitor a level (F) of a medium (19) located in the process area of a container (17) using a microwave time-of-flight measurement method, consisting of a transmitter (21) and an antenna unit (3), which comprises at least a waveguide (4) and a horn-shaped radiating element (5), wherein a process separation element (6) which is permeable to microwaves is inserted on the waveguide (4) for process separation between the transmitter (21) and the horn-shaped radiating element (5) in contact with the process area,
**characterized in that**
the process separation element (6) is designed as a hollow body (7) with at least a tubular hollow body area (8) that is adapted to the shape of the waveguide (4) and a pointed hollow body area (9) that continues from the tubular hollow body area in the direction of the horn-shaped radiating element (5) with a wall thickness (d) that is adapted to the reflection of the microwave signals (2),
**in that** an absorber element (11) is fitted between the waveguide (4) and the process separation element (6), and
**in that** a metal pipe, which is electrically connected to the metal waveguide (4), or a metal coating (12) of the inner wall (13) of the tubular hollow body area (8) of the process separation element (6), said metal coating being electrically connected to the metal waveguide (4), is introduced in the tubular hollow body area (8) of the process separation element (6) as far as the pointed hollow body area (9).

2. Level transmitter as claimed in Claim 1
**characterized in that**
the adapted wall thickness (d) of the process separation element (6), particularly in the pointed hollow body area (9), is consistently structured according to around half the wavelength (λ/2) of the transmitted microwave signal (2) or an integer multiple thereof.

3. Level transmitter as claimed in Claim 1
**characterized in that**
the adapted wall thickness (d) of the process separation element (6), particularly in the pointed hollow body area (9) is designed in a range of one to five millimeters.

4. Level transmitter as claimed in at least one of the Claims 1, 2 or 3,
**characterized in that**
the tubular hollow body area (8) of the process separation element (6) is designed as a circular cylinder and **in that** the pointed hollow body area (9) of the process separation element (6) has a conical shape in the direction of the process area.

5. Level transmitter as claimed in at least one of the Claims 1, 2 or 3,
**characterized in that**
the tubular hollow body area (8) of the process separation element (6) is designed as a rectangular cylinder and the pointed hollow body area (9) of the process separation element (6) is shaped in the form of a V or pyramid in the direction of the process area.

6. Level transmitter as claimed in at least one of the previous claims,
**characterized in that**
the pointed hollow body area (9) has an acute angle and **in that** the semi-pointed angle Phi corresponds to a 90° angle minus a Brewster angle (B).

7. Level transmitter as claimed in at least one of the previous claims,
**characterized in that**
in the direction of the waveguide (4) the process separation element (6) has a collar area (15) on the tubular hollow body area (8), whereby a tight clamp fastening of the collar area (15) of the process separation element (6) is designed using a support element (16) screwed and/or welded on the waveguide (4).

8. Level transmitter as claimed in at least one of the previous claims,
**characterized in that**
the process separation element (6) hermetically seals the waveguide (4) from the process area by means of at least one seal (10), particularly an O-ring seal, a graphite packing gland seal or a ceramic metal solder connection.

9. Level transmitter as claimed in at least one of the previous claims,
**characterized in that**
the absorber element (11) is particularly a silicon carbide disk.

10. Level transmitter as claimed in at least one of the previous claims,
**characterized in that**
the process separation element (6) is made from a ceramic material, a plastic material, a dielectric composite material, such as a fiber-reinforced plastic, a plastic filled with ceramic parts or a glass.

## Revendications

1. Transmetteur de niveau destiné à la détermination et la surveillance d'un niveau (F) d'un produit se trouvant dans la chambre de process d'un réservoir (17) au moyen d'un procédé de mesure du temps de propagation de micro-ondes, constitué d'un transmetteur (21) et d'une unité d'antenne (3), qui est constituée au moins d'un guide d'ondes (4) et d'un élément rayonnant (5) en forme de corne, un élément séparateur de process (6) perméable aux micro-ondes étant inséré sur le guide d'ondes (4) pour la séparation du process entre le transmetteur (21) et l'élément rayonnant (5) en forme de corne entrant en contact avec la chambre de process,
**caractérisé**
**en ce que** l'élément séparateur de process (6) est conçu en tant que corps creux (7) avec au moins une zone tubulaire de corps creux (8) adaptée à la forme du guide d'ondes (4) et une zone pointue de corps creux (9) qui y est raccordée en direction de l'élément rayonnant en forme de corne (5) avec une épaisseur de paroi (d) adaptée à la réflexion des signaux à micro-ondes (2),
**en ce qu'**est monté un élément absorbeur (11) entre le guide d'ondes (4) et l'élément séparateur de process (6), et
**en ce qu'**est monté, dans la zone tubulaire du corps creux (8) de l'élément séparateur de process (6) jusqu'à la zone pointue de corps creux (9) un tube métallique relié électriquement avec le guide d'ondes métallique (4) ou un revêtement métallique (12) relié électriquement avec le corps creux métallique (4) de la paroi intérieure (13) de la zone tubulaire de corps creux (8) de l'élément séparateur de process (6).

2. Transmetteur de niveau selon la revendication 1
**caractérisé**
**en ce que** l'épaisseur de matériau (d) adaptée de l'élément séparateur de process (6) est conçue, notamment dans la zone pointue de corps creux (9), régulièrement selon environ la demi-longueur d'onde (λ/2) du signal à micro-ondes émis (2) ou selon un multiple entier de celui-ci.

3. Transmetteur de niveau selon la revendication 1
**caractérisé**
**en ce que** l'épaisseur de matériau (d) adaptée de l'élément séparateur de process (6) est conçue, notamment dans la zone pointue de corps creux (9), dans une zone de un à cinq millimètres.

4. Transmetteur de niveau selon au moins l'une des revendications 1, 2 ou 3,
**caractérisé**
**en ce que** la zone tubulaire de corps creux (8) de l'élément séparateur de process (6) est conçue en tant que cylindre circulaire et en ce que la zone pointue de corps creux (9) de l'élément séparateur de process (6) présente une forme conique en direction de la chambre de process.

5. Transmetteur de niveau selon au moins l'une des revendications 1, 2 ou 3,
**caractérisé**
**en ce que** la zone tubulaire de corps creux (8) de l'élément séparateur de process (6) est conçue en tant que cylindre rectangulaire et en ce que la zone pointue de corps creux (9) de l'élément séparateur de process (6) présente une forme de coin ou pyramidale en direction de la chambre de process.

6. Transmetteur de niveau selon au moins l'une des revendications précédentes,
**caractérisé**
**en ce que** la zone pointue de corps creux (9) présente un angle aigu et en ce que le demi-angle aigu Phi correspond à un angle de quatre-vingt-dix degrés moins un angle de Brewster (B).

7. Transmetteur de niveau selon au moins l'une des revendications précédentes,
**caractérisé**
**en ce que** l'élément séparateur de process (6) présente une partie de col (15) sur la zone tubulaire de corps creux (5), ce par quoi une fixation par serrage de la partie de col (15) de l'élément séparateur de process (6) est conçue au moyen d'un élément support (16) vissé et/ou soudé sur le guide d'ondes (4).

8. Transmetteur de niveau selon au moins l'une des revendications précédentes,
**caractérisé**
**en ce que** l'élément séparateur de process (6) obture au moyen d'au moins un joint (10), notamment un joint torique, un joint de presse-étoupe en graphite ou une connexion soudée céramique-métal, le guide d'ondes (4) de façon hermétique par rapport à la chambre de process.

9. Transmetteur de niveau selon au moins l'une des revendications précédentes,
**caractérisé**
**en ce que** l'élément absorbeur (11) est notamment un disque en carbure de silicium.

10. Transmetteur de niveau selon au moins l'une des revendications précédentes,
**caractérisé**
**en ce que** l'élément séparateur de process (6) est constitué d'un matériau en céramique, d'une matière plastique, d'un matériau composite diélectrique, tel qu'une matière plastique renforcée de fibres, d'une matière plastique remplie de parts de céramique ou d'un verre.
